# EUROPEAN PATENT APPLICATION

(11) **EP 1 936 678 A2**
(43) Date of publication of application: **25.06.2008**
(21) Application number: 07150277.7
(22) Date of filing: 20.12.2007
(51) Int. Cl.: H01L 21/68

(54) **A method for bonding and releasing a die or substrate to/from a carrier and corresponding intermediate product**

(30) Priority: 21.12.2006 US 876240 P; 16.05.2007 EP 07108370
(71) Applicant: Interuniversitair Microelektronica Centrum (IMEC), 3001 Leuven (BE)
(72) Inventor: Swinnen, Bart, B-3220, HOLSBEEK (BE); Beyne, Eric, B-3001, LEUVEN (BE)
(74) Representative: pronovem

(57) **Abstract**

The present invention is related to a method for bonding two elements by means of a bonding agent such as a glue layer, wherein said bonding agent is removable, and where in between said bonding agent and at least one element, a sacrificial layer is applied which is selectively removable with respect to that element.
The 'elements' are preferably a die or substrate, which is bonded to a carrier wafer. The nature and type of the die or substrate and of the carrier, can vary within the scope of the present invention. The invention is equally related to a composite substrate obtainable by the method of the invention.

## Description

### Field of the Invention

The present invention is related to the field of microelectronics. It is related more specifically to techniques for substrate or die to carrier bonding as used for instance in microelectronics packaging and/or stacking technologies.

### State of the Art

Substrates or dies often need to be bonded temporarily to carrier wafers, on which they may be further handled, processed or thinned. This is for instance the case when performing wafer or die thinning where the wafer or die is temporarily bonded to a carrier (typically used for extreme wafer thinning). An example of such a process can be found in US6506664, in some aspects relating to the stacking of Ultra Thin Chips.

Glue layers can be used to achieve such a temporary bond. Such glue or bonding layers need to be compatible with all processes performed on the substrate or die while it is bonded. For instance mechanical and chemical stability is required.

When temporarily bonding a carrier to a substrate or die, depending on the glue layer (more generally bonding layer) used, the carrier can be released chemically (e.g. through etch or dissolution of the glue layer), thermally (through phase change or decomposition of the glue layer material), or under illumination (e.g. through breaking of a molecular bond).

Thermally decomposable glue layers and glue layers which are decomposable under illumination by radiation of a predetermined frequency spectrum have the advantage over chemically removable glues that carrier release is often easier or faster when compared to chemical release (especially for large bonded areas). When using a chemical release (corresponding to a chemically removable glue) the glue must be brought in contact with a chemical substance, and for large bonded areas this can occur only from the outer region inwards, resulting in a relatively slow release process.

In the case of release by illumination, measures must be taken that the radiation can easily and preferably substantially uniformly reach the glue or bonding layer, eg by making one of the bonded elements transparent to the radiation. Transparent should be understood as allowing enough radiation to pass through to achieve the effect of release. These insights also apply to certain embodiments.

For many thermally decomposable glue layers available today, it is very difficult or impossible to remove residues after the glue decomposition, especially without impacting the substrate or die, which is typically at least partially processed. For instance high temperature processing as e.g. copper to copper thermo compression bonding has shown to affect certain polymer glue layers, such that upon removal of this layer residues are left which are not removable or very difficult to remove.

Another technique involves the use of a sacrificial layer used for temporarily attaching the die to a carrier. The release is obtained by etching the sacrificial layer from the sides, which is however a time-consuming operation.

Document DE10320375 is related to a method for temporarily fixing two planar workpieces, e.g. a processed wafer to a glass carrier, wherein both components receive a release layer, and wherein the actual bond is established by a glue layer. The release of the workpieces takes place in a wet chemical process, wherein the release layers are dissolved and the glue layer is left over as waste.

Document US2004/0009649 is related to a method for bonding a wafer to a substrate, wherein the front surface of the wafer is temporarily attached to a support, thinned, and subsequently attached to the substrate, whereafter the support is released from the wafer surface. Optionally, a low stress material may be applied to the front surface of the wafer before attaching the wafer to the support.

### Aims of the Invention

The present invention aims to provide a method for bonding a die or substrate to a carrier, which alleviates or avoids the problems of the prior art.

### Summary of the Invention

The invention is related to methods and devices as described in the appended claims. In particular, as claimed in claim 1, the invention is concerned with a method for bonding and releasing 2 elements, the bonding taking place by means of a bonding agent such as a glue layer, wherein said bonding agent is removable, and where in between said bonding agent and at least one element, a sacrificial layer is applied which is selectively removable with respect to that element. The result of the bonding step is a composite substrate. The method further comprises the steps of subjecting said composite substrate to a temperature increase, wherein said first and second element are released or become easily releasable due to a phase change of the removable attachment layer, and removing the sacrificial layer after the release of said first and second element, by means of an etching agent or a solvent, hereby also removing residues left from the removable attachment layer. Said temperature increase takes place up until or above a transformation temperature, but below a critical temperature being the maximum temperature which the first element can withstand without incurring damage. In the preferred case, the residues are not etchable in said etching agent, and are thus removed indirectly. Further embodiments of the method of the invention are disclosed in combinations of claim 1 with one or more of the dependent claims 2 to 11.

The 'elements' are preferably a die or substrate, which is (usually temporarily) bonded to a carrier wafer. The nature and type of the die or substrate and of the carrier, can vary within the scope of the present invention. The die or substrate can comprise Back end of line (BEOL) components or structures and Front end of line (FEOL) components or structures and/or vias through the substrate or die, wherein the FEOL components/structures and the vias through the substrate are both optional. BEOL and FEOL are typical. The FEOL corresponds to operations performed on the semiconductor wafer in the course of device manufacturing up to first metallization. The BEOL corresponds to operations performed on the semiconductor wafer in the course of device manufacturing following first metallization.

As expressed in claim 12, the invention is equally related to a composite substrate comprising a first element bonded onto a second element by means of a bonding layer, characterized in that said bonding layer comprises at least 2 sub layers :
- a sacrificial layer being selectively removable with respect to the first element in contact with a first main surface of said first element, and
- a removable attachment layer comprising a material which can change from solid to non solid phase at a temperature below a critical temperature, in contact with said sacrificial layer.

Said critical temperature is the maximum temperature which said composite substrate can withstand without incurring damage. The invention is equally related to substrates as described in combinations of claim 12 with one or more of the dependent claims 13 to 21.

### Brief Description of the Drawings

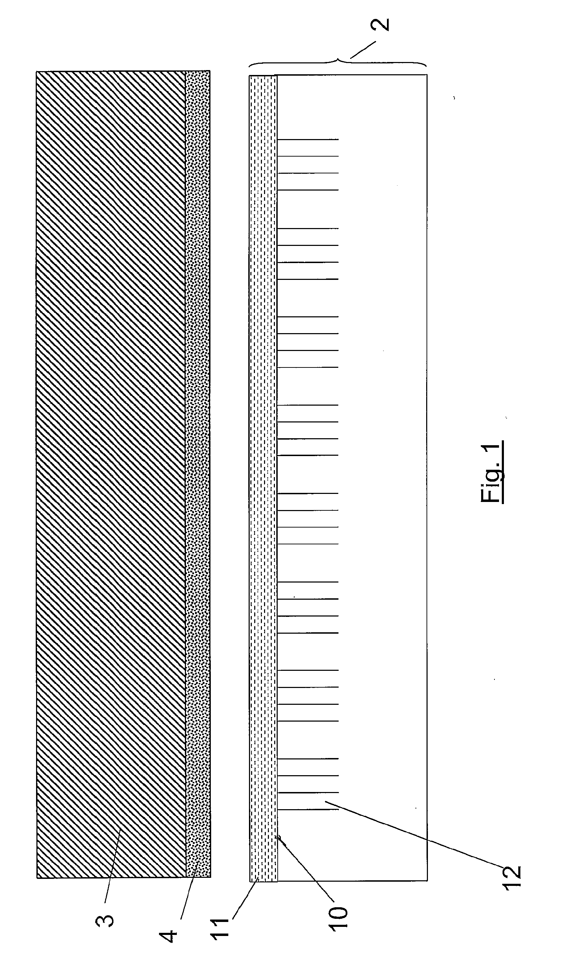

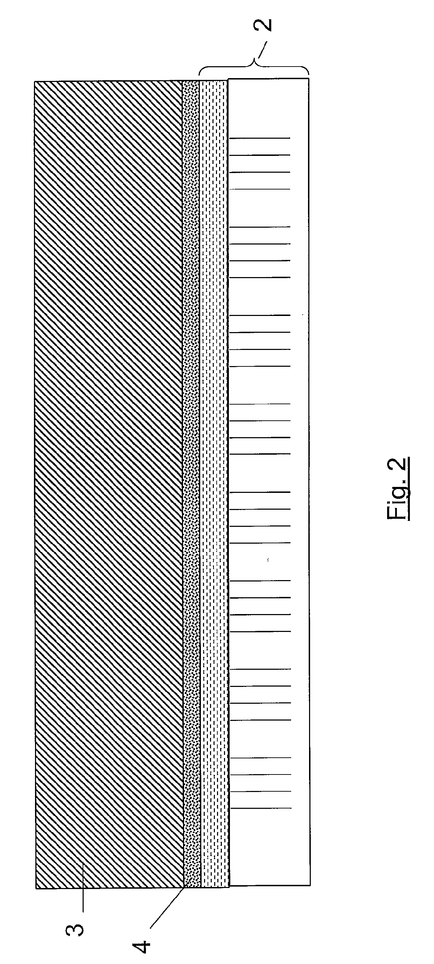

Fig. 1 and Fig. 2 illustrate prior art processes in which a carrier is bonded to a die or substrate (the figures illustrate Back (11) and Front (10) end of line and through-the-substrate-or-die via's 12 which are optional, but typical) by means of a single glue layer. In Fig. 2 the thinning after bonding process is illustrated.

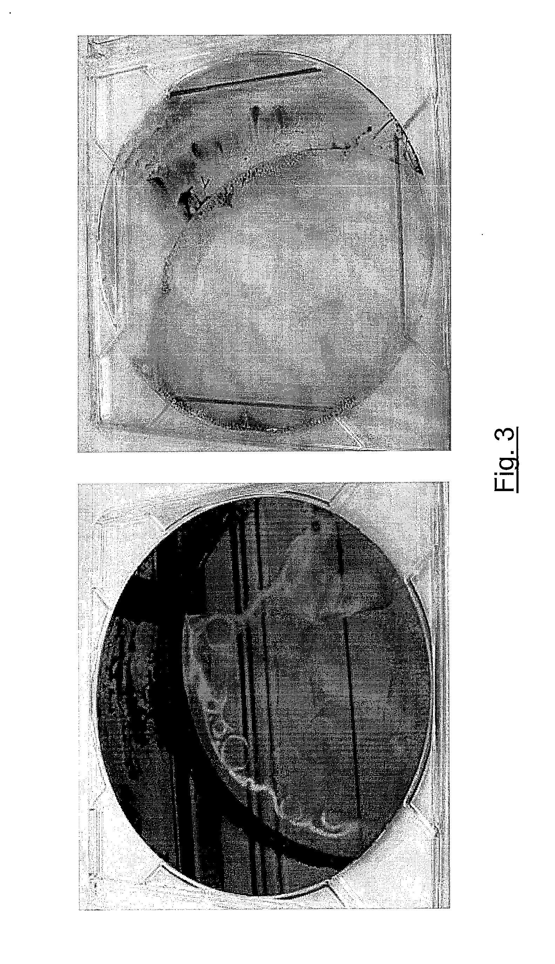

Fig. 3 shows a Si device wafer and a glass carrier wafer after release of a temporary glue layer (Unity).

Fig. 4A and Fig. 4B show embodiments according to the present invention with the removable attachment layer on the sacrificial layer (Fig. 4B) or on the first main surface of the carrier substrate (Fig. 4A)

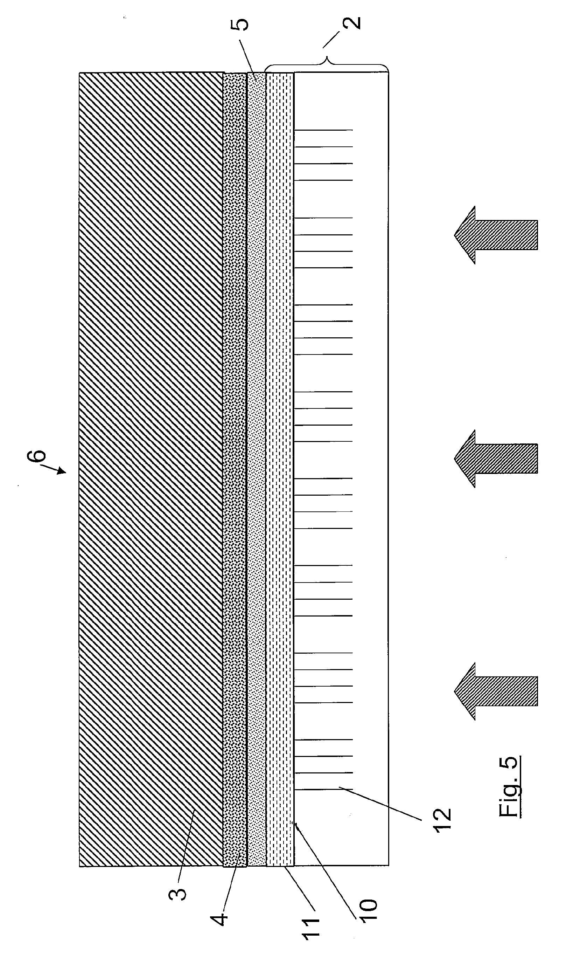

Fig. 5 illustrates the thinning after bonding process according to certain embodiments of the present invention.

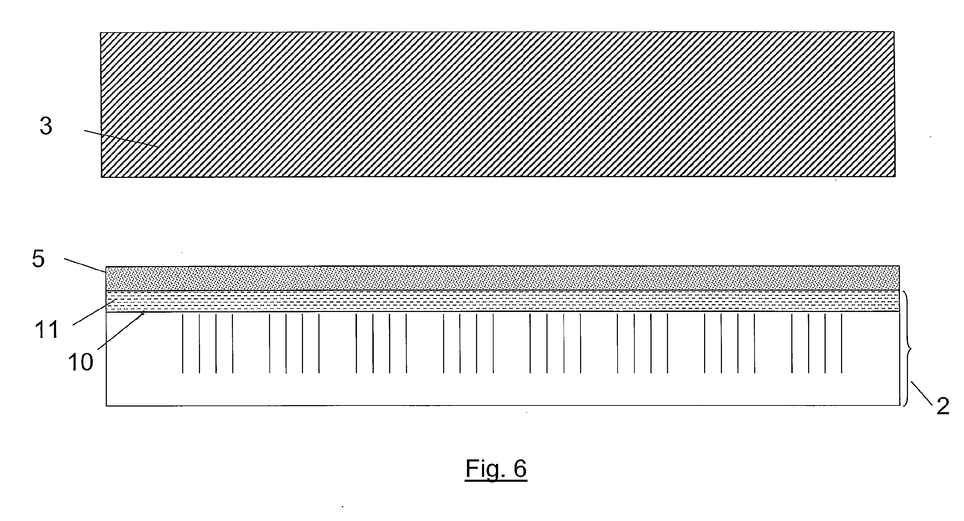

Fig. 6 illustrates that the removable attachment layer has been removed, hereby separating the carrier and die or substrate again.

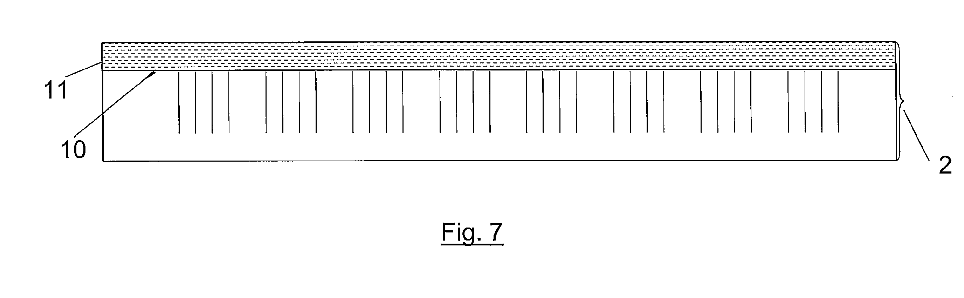

Fig. 7 illustrates the further removal of the sacrificial layer, whereby residues left from the removable attachment layer are eliminated at the same time.

### Detailed Description of the Invention

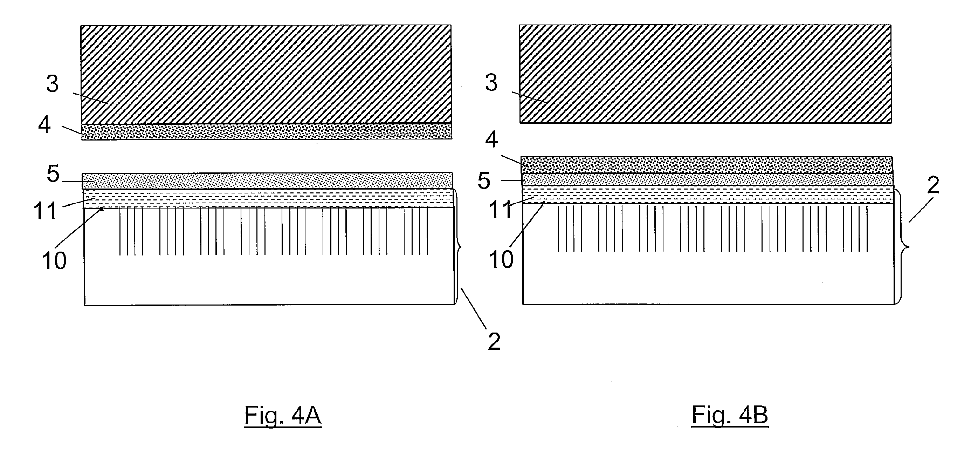

With reference to figures 4A and 4B, the invention is related to a method for producing a composite substrate by bonding a first element (2) having a main surface, to a second element (3) having a main surface, the method comprising the steps of :
- Providing the first element (2), and providing a sacrificial layer (5) on said main surface of the first element, the sacrificial layer (5) being selectively removable with respect to the first element;
- providing the second element (3),
- applying a removable attachment layer (4) on top of the sacrificial layer or on top of the main surface of the second element,
- bonding the first element (2) to the second element by contacting one element to the removable attachment layer present on the other element.

The first element is preferably a die or substrate. The second element is preferably a carrier wafer. The die or substrate may comprise Back End Of Line (BEOL) or Front End of Line (FEOL) layers 11 and 10. The die or substrate may also comprise via's 12.

The resulting composite substrate comprises a bonding layer, which essentially consists of the sacrificial layer 5 and the removable attachment layer 4.

In particular, the invention concerns a method for forming a composite substrate (6) by bonding a die or substrate (2) to a carrier (3), comprising:
providing a sacrificial layer (5) on a first main surface of the substrate or the die, the sacrificial layer (5) being selectively removable with respect to the substrate or die;
providing a carrier (3), comprising a first main carrier surface;
applying a removable layer (4) on top of the sacrificial layer or on top of a first main carrier surface;
bonding the die or the substrate (2) with the carrier (3) by means of a bonding layer comprising a stack of sub layers formed by the sacrificial layer and the removable layer.

The sacrificial layer and removable layer are preferably in physical contact. The bonding layer can essentially consist of the sacrificial layer and the removable layer.

The term "selectively removable with respect to the substrate or die" should be understood as removable such that the substrate or die is not affected by the removal step, i.e. such that the die or substrate is left untouched or is sufficiently untouched in view of the required performance.

The removable attachment layer can comprise a material which changes from solid to non-solid phase at a transformation temperature below a critical temperature on top of the sacrificial layer or on top of the main carrier surface, the critical temperature being the maximum temperature which the die or substrate and preferably the sacrificial layer, can withstand without incurring damage.

The removable attachment layer can also comprise or consist of a material which changes from solid to non-solid phase when illuminated with electromagnetic radiation of a predetermined frequency spectrum.

The transformation from solid to non-solid phase of the material of the removable attachment layer can be a transformation from solid to gas (sublimation or decomposition) or a transformation from solid to liquid (melting). In the first case the die or substrate and the carrier will be released from each other essentially when the transformation takes place(or: the first element and the second element). In the latter case (melting) the substrate or die and the carrier may still be attached to each other due to adhesion, but are easily separable. They can for instance be glided off each other in the direction of their main surfaces.

In the case of melting, typically a wax material can be used or a thermo-plastic material (typically a thermally decomposable polymer) or thermoplastic polymer. A polyimide can also be used in the removable attachment layer.

In the case of sublimation/decomposition, materials with limited thermal stability and sharp transitions from solid to gas phase can be used. Materials with slow transitions are also possible. Currently available materials include Unity from Promerus inc. Advantageously types of materials that are used in Cu-low-k applications to generate pores can be used.

The critical temperature is the temperature below which one must stay in order to avoid any negative influence, damage or change to the die or substrate due to this temperature. This temperature is application dependent: for instance typically about 200 degrees C for memory applications or about 400 degrees C for CMOS devices.

The transformation temperature or transformation thermal budget should be below the critical temperature or critical thermal budget.

It should be noted that the parameter "critical temperature" has been chosen in defining certain embodiments. The critical temperature may be dependent on the time period of the temperature step. One could refer then to a critical thermal budget. The same applies for the transformation temperature, which can be referred to as a transformation thermal budget. For reasons of clarity the reference to a temperature has been preferred, but the terms can be replaced by the alternatives as mentioned above, in the following description.

According to one embodiment, the die or substrate is further processed after a phase transition from solid to liquid phase of the removable attachment layer has occurred or while said removable attachment layer is substantially or completely in a liquid state.

The sacrificial layer is preferably etchable by means of an etching agent. It can be etchable by dry or wet etching. The sacrificial layer can alternatively be soluble in a solvent.

According to an embodiment, a further planarization of the removable attachment layer is applied before bonding, which may improve an optional thinning process of the die or substrate, especially when thinning via CMP or grinding or other techniques known in the art which exert pressure on the surface to be thinned.

The method used for forming composite substrates can typically be a base method (i.e. a method used as such, and not in combination with further method steps), allowing the possibility of handling, thinning and processing temporarily bonded substrates or dies on a carrier substrate.

According to an embodiment, the substrate or die is further thinned after the bonding step. The thinning can be performed by any state of the art technique, as for instance Chemical Mechanical Polishing, grinding, wet or dry etching.

The thinning can be such that the die or substrate has a thickness larger than about 50 or larger than about 100, 200, 300, 400, 500, 600 micron before thinning and a smaller thickness after thinning as for instance a smaller thickness smaller than about 50, 40, 30, 20,10, 5 micron afterwards.

In certain embodiments, the second main surface of the die or substrate (which may have been thinned, in which case the surface can be referred to as "thinned surface") can be further processed. For instance solder balls can be applied, a backside diffusion barrier, e.g. a Cu diffusion barrier such as a SiN4 layer or a metallic barrier (Ta, TaN, Ti, TiN) can be applied, or a layer can be deposited. Etching can be performed locally. Backside patterning can be performed.

Post processing can be associated with a maximal post processing temperature or post processing thermal budget. In embodiments comprising a thermal release, the maximal post processing temperature or post processing budget is preferably below the transformation temperature or transformation thermal budget respectively. The maximal post processing temperature or post processing budget may also be above the transformation temperature or transformation thermal budget respectively, as long as the transformation concerns a solid to liquid phase change of the removable attachment layer, which results in a still processable composite substrate; i.e. resulting in a sufficiently stable bond on which processing is still possible.

The composite structure can be subjected to a temperature increase up until or above the transformation temperature (as described in the previous paragraph where it can occur during an associated post processing act), but below the critical temperature, whereby the carrier wafer and the die or substrate are released or become easily releasable due to a phase change of the removable attachment layer.

According to the invention, the sacrificial layer is further removed (for instance by means of the etching agent or solvent) from the die or substrate, hereby also removing residues left from the removable attachment layer.

According to an embodiment, an etch-stop layer (not shown) is provided between the die or substrate and the sacrificial layer, wherein the etch-stop layer is resistant to the etching agent or solvent. Alternatively, the die may comprise a surface which is already resistant to the etching agent or solvent. Seen in another way, the sacrificial layer and means for removing said sacrificial layer, which are often associated, can be chosen in function of the dies or substrates surface if no separate etch stop layer is provided.

As the die or chip surface has typically exposed metal pads and dielectrics, the sacrificial layer is preferably a material that can be removed with high selectivity with respect to these metals and dielectrics. E.g. when the chip materials are Cu and a nitride passivation, this material could be silicon oxide (Selective wet etch using e.g. HF diluted solutions possible), or a metal as aluminum or Titanium that can be etched selectively with respect to Cu.

At the same time, the sacrificial layer is preferably isotropically etchable, because of the presence - on the sacrificial layer - of residues of the glue layer. Such residues are normally not etched by the etching solvent, so the areas where residues are present need to be underetched by the solvent, in order to remove the residues. If the sacrificial layer is anisotropically etched, the residue areas would remain and the sacrificial layer would only be removed in areas where no residues are present.

Often the surface of the die or substrate on which the sacrificial layer is applied would need a cleaning step anyway; the removal of the sacrificial layer may provide such a cleaning contemporarily, i.e. simultaneously with the removal. This means that only 1 act more is necessary in such embodiments when compared to the state of the art, where no sacrificial layer is applied, namely the extra act of providing the sacrificial layer.

Different sacrificial layers and associated means for removing said sacrificial layer may be used for different materials present at the chip surface.

Composite substrates generated by the methods according to certain embodiments are also disclosed below. Corresponding features, advantages and definitions from the description of the method are valid and applicable for the devices and are not necessarily repeated.

The invention is equally related to a composite substrate produced by the method of the invention. Such a composite substrate comprises a first element bonded onto a second element by means of a bonding layer, characterized in that the bonding layer comprises at least 2 sub layers, a sacrificial layer being selectively removable with respect to the first element, and a removable attachment layer comprising a material which can change from solid to non solid phase at a temperature below a critical temperature, said removable attachment layer in contact with the sacrificial layer, the critical temperature being the maximum temperature which the composite substrate can withstand without incurring damage. In other embodiments the removable attachment layer changes from solid to non solid phase when illuminated with radiation of a predetermined spectrum.

The sacrificial layer can be etchable by means of an etching agent, by dry or wet etching. The sacrificial layer can also be soluble in a solvent. The sacrificial layer is preferably isotropically etchable. The first main surface of the die or substrate can have a non-flat topology.

The first main surface of the die or substrate can comprise an etch-stop layer, which is resistant to the etching agent. The etch-stop layer can be patterned.

The die or substrate can have a thickness below about 100 micron, or according to other embodiments, respectively below 90, 80, 70, 60, 50, 40, 30, 20, 10, or 5 micron.

The removable attachment layer can comprise a wax material or a thermo-plastic material (typically a thermally decomposable polymer) or thermoplastic polymer. Materials with limited thermal stability and sharp transitions from solid to gas phase can be used. Materials with slow transitions are also possible. Currently available materials include Unity from Promerus inc. Advantageously, types of materials that are used in Cu-low-k applications to generate pores can be used.

The sacrificial layer can be for instance, when the chip materials are Cu and a nitride passivation, silicon oxide (Selective wet etch using e.g. HF diluted solutions possible), or a metal, e.g. aluminum or Titanium that can be etched selectively with respect to Cu.

## Claims

1. A method for bonding and releasing a first element (2) having a main surface, to and from a second element (3) having a main surface, the method comprising the steps of :
- Providing the first element (2), and providing a sacrificial layer (5) on said main surface of the first element, the sacrificial layer (5) being selectively removable with respect to the first element;
- providing the second element (3),
- applying a removable attachment layer (4) on top of the sacrificial layer or on top of the main surface of the second element,
- bonding the first element (2) to the second element by contacting one element to the removable attachment layer present on the other element, thereby obtaining a composite substrate,
- subjecting said composite substrate to a temperature increase, wherein said first and second element are released or become easily releasable due to a phase change of the removable attachment layer (4),
- removing the sacrificial layer (5) after the release of said first and second element, by means of an etching agent or a solvent, hereby also removing residues left from the removable attachment layer.

2. The method according to claim 1, wherein said first element is a die or substrate, and said second element is a carrier wafer.

3. The method according to claim 1, wherein said sacrificial layer is removable by selective etching with respect to the first element.

4. The method according to claim 1, wherein said sacrificial layer is soluble in a solvent.

5. The method according to claim 1, wherein said sacrificial layer is isotropically etchable.

6. The method according to claim 1, wherein said removable attachment layer is removable through its decomposition from a solid to a non-solid state, wherein said decomposition is obtained by a thermal step or by an illumination step.

7. The method according to claim 1, further comprising the step of providing an etch-stop layer on the main surface of the first element, and wherein the sacrificial layer is applied on top of the etch-stop layer.

8. The method according to claim 1, further comprising the step of planarizing the removable attachment layer before bonding.

9. The method according to claim 1, further comprising the step of thinning the first element after bonding said first element to the second element.

10. The method according to claim 9, wherein said thinning is performed by Chemical Mechanical Polishing, grinding or etching.

11. The method according to claim 9 or 10, wherein said first element is a die or substrate, and wherein said die or substrate has a thickness >50**µ**m before thinning and < 50**µ**m after thinning.

12. A composite substrate comprising a first element (2) bonded onto a second element (3) by means of a bonding layer, **characterized in that** said bonding layer comprises at least 2 sub layers :
- a sacrificial layer (5) being selectively removable with respect to the first element in contact with a first main surface of said first element, and
- a removable attachment layer (4) comprising a material which can change from solid to non solid phase at a temperature below a critical temperature, in contact with said sacrificial layer.

13. The composite substrate according to claim 12, wherein said first element (2) is a substrate or die, and said second element is a carrier wafer (3).

14. A composite substrate according to claim 12, wherein said sacrificial layer (5) is etchable by means of an etching agent

15. A composite substrate according to claim 12, wherein said sacrificial layer (5) is soluble in a solvent.

16. A composite substrate according to claim 12, wherein said sacrificial layer (5) is isotropically etchable.

17. A composite substrate according to claim 13, wherein said first main surface of said die or substrate has a non-flat topology.

18. A composite substrate according to claim 12, wherein said first main surface of said first element (2) comprises an etch-stop layer, which is resistant to said etching agent.

19. A composite substrate according to claim 13, wherein said die or substrate has a thickness below 100 micron.

20. A composite substrate according to claim 12, wherein said sacrificial layer comprises Silicon Oxide or Aluminium or Titanium.

21. A composite substrate according to claim 12, wherein said removable attachment layer is a glue layer, a polymer layer or wax layer.
